# EUROPEAN PATENT APPLICATION

(11) **EP 3 493 337 A1**
(43) Date of publication of application: **05.06.2019**
(21) Application number: 17204632.8
(22) Date of filing: 30.11.2017
(51) Int. Cl.: H01S 5/022, H01S 5/042, H01S 5/183, H01S 5/42

(54) **VERTICAL CAVITY SURFACE EMITTING LASER (VCSEL) DEVICE WITH IMPROVED RELIABILITY**

(71) Applicant: Koninklijke Philips N.V., 5656 AE Eindhoven (NL)
(72) Inventor: WEIGL, Alexander, 5656 AE Eindhoven (NL)
(74) Representative: de Haan, Poul Erik

(57) **Abstract**

The invention describes a Vertical Cavity Surface Emitting Laser device (100) comprising at least one first optical resonator, a first electrode (210) and a second electrode (220), wherein the first electrode (210) and the second electrode (220) are arranged to electrically pump the first optical resonator during operation of the Vertical Cavity Surface Emitting Laser device (100), wherein the first electrode (210) or the second electrode (220) comprises at least one electrically conducting layer (132), wherein the electrically conducting layer (132) is arranged around an extended area comprising a first light emission area (20) of the first optical resonator and at least one extension area (40) such that the extended area is bigger than the first light emission area (20). The Vertical Cavity Surface Emitting Laser device (100) may be integrated in a Vertical Cavity Surface Emitting Laser module or in an optical sensor (300). The optical sensor may be integrated in a mobile communication device (400).

The invention further relates to a method of manufacturing such a Vertical Cavity Surface Emitting Laser device (100) and a metallization lift off mask 10 which may be used in such a method of manufacturing.

## Description

### FIELD OF THE INVENTION

The invention relates to a Vertical Cavity Surface Emitting Laser (VCSEL) device. The invention further relates to a VCSEL module, an optical sensor comprising such a VCSEL device or module and a mobile communication device comprising such an optical sensor. The invention further relates to a method of manufacturing the VCSEL device and a metallization lift off mask which may be used in the method of manufacturing the VCSEL device.

### BACKGROUND OF THE INVENTION

VCSEL devices may be used within mobile communication devices as smartphones for sensing applications. Such sensing applications maybe time of flight measurements for distance detection, camera autofocus, 3-D imaging of a scene or a gesture based user interface. Price and reliability of the devices are key differentiators.

### SUMMARY OF THE INVENTION

It is an object of the present invention to provide a VCSEL device which can be manufactured with high yield and improved reliability.

According to a first aspect a Vertical Cavity Surface Emitting Laser (VCSEL) device is provided. The VCSEL device comprises at least one first optical resonator, a first electrode and a second electrode. The first electrode and the second electrode are arranged to electrically pump the first optical resonator during operation of the Vertical Cavity Surface Emitting Laser device. The first electrode or the second electrode comprises at least one electrically conducting layer. The electrically conducting layer is arranged around an extended area comprising a first light emission area of the first optical resonator and at least one extension area such that the extended area is bigger than the first light emission area. The extension area may, for example, comprise at least one notch extending the extended area beyond the size of the first light emission area. A notch may be an area which is not covered by the electrically conducting layer and which forms one connected area with the light emission area, wherein the notch extends the area not covered by the electrically conducting layer in one direction with respect to a center of the light emission area. The extended area only partly surrounds the light emission area. The shape of the light emission area may, for example, be circular, rectangular, triangular, star-shaped etc. The extension area may break symmetry of the shape of the light emission area which is used for electrically pumping the VCSEL device.

The optical resonator or laser cavity of the VCSEL device comprises an active layer which is sandwiched between two mirrors such as Distributed Bragg Reflectors (DBRs). A first mirror is highly reflective (>99%) and a second mirror does have a somewhat smaller reflectivity (>95%) in order to enable laser emission. The optical resonator may further comprise additional layers like, for example, a current confinement layer and further intermediate layers enabling high-quality optical resonators which are well known to those skilled in the art.

The electrical contact or electrode surrounding the light emission area for electrically pumping the VCSEL device is usually manufactured by means of a lift off process. The electrically conducting (e.g. metal) layer above the light emission area is removed by removing the underlying sacrificial layer (e.g. photoresist). This usually results in a ring-shaped electrode surrounding the light emission area. Experiments have shown that the metal or conducting material originally covering isolated small areas (e.g. above a light emission area) is removed during lift off in a first step but there is a substantial risk that the small metal particle sag back to the surface of the VCSEL device. Furthermore, the small size of the small metal particles makes it difficult to detect these deposits. The contamination caused by the small metal particles decreases yield during manufacturing of the VCSEL devices and may cause reliability issues during operation of the VCSEL devices. Further experiments have shown that the risk of re-deposition of removed metal particles after or during lift off can substantially decreased if the size of these particles is increased. It is therefore proposed to extend the size of the areas from which the respective conducting layer is removed beyond the functionality of the respective structure. The size of the extended area comprising the first light emission area is therefore increased up to a level such that probability of re-deposition of the removed material is reduced to an acceptable level. In general the size of all areas (e.g. alignment marks) from which the conducting layer is removed is increased up to this level.

The extended area maybe at least 1.5 times bigger than the first light emission area. The extended area or in general each area from which the electrically conducting layer is removed may be characterized by a size of at least 30 µm². Experiments have shown that likelihood of re-deposition of removed parts of the conducting layer with a size of more than 30 µm² is at an acceptable low level.

The at least one notch may be arranged such that symmetry of current injection around the light emission area during operation of the Vertical Cavity Surface Emitting Laser device is disturbed. A part of the border of the structured electrically conducting layer may, for example, define a border of the first light emission area. The notch may interrupt the border in order to increase the extended area. The respective first or second electrode would, for example, not be circular symmetric (ring-shaped). Experiments have shown that the broken symmetry of current injection has only minor influence with respect to optical characteristics of the VCSEL device.

The extended areas may be used for each critical layer which is processed by a lift off process as described above and below.

The Vertical Cavity Surface Emitting Laser module may comprise at least a second optical resonator with a second light emission area. The extended area comprises the first light emission area and the second light emission area. The extension area (or notch) may enable a connection between two, three, four or more adjacent areas (light emission areas, alignment marks etc.) from which the conducting layer has to be removed.

The electrically conducting layer may be arranged to electrically pump the first optical resonator and the second optical resonator in parallel. The electrically conducting layer may provide in this case a common contact pad for providing electrical current to the first and second and optionally further third, fourth or more optical resonators.

According to a second aspect a Vertical Cavity Surface Emitting Laser module comprising the Vertical Cavity Surface Emitting Laser device according to any embodiment discussed above is provided. The Vertical Cavity Surface Emitting Laser module further comprises a driving circuit for electrically pumping the optical resonator. The electrical driving circuit is arranged to pump the optical resonator or resonators by supplying an electrical current to the respective active layer via the first and the second electrode. The electrical driving circuit may be powered by means of an external power source which may be connected by means of an electrical connector.

The Vertical Cavity Surface Emitting Laser module may be comprised by an optical sensor. The optical sensor may, for example, comprise at least one photo detector being adapted to receive reflected laser light of a corresponding laser pulse emitted by the Vertical Cavity Surface Emitting Laser device. The optical sensor may further comprise an evaluator which is adapted to identify the reflected laser light of the corresponding laser pulse. The evaluator is further adapted to determine a time of flight between a time of reception of the reflected laser light and a time of emission of the corresponding laser pulse. Optical sensors for time of flight (ToF) measurements may be used in mobile devices (e.g. smart-phones) for many purposes like distance detection, camera auto focus, 3D imaging of a scene or a gesture based user interface. An advantageous system uses a VCSEL device combined with a photodiode (e.g. avalanche photodiode) and electronics to measure the travel time of light from the VCSEL towards the scene and back to the sensor. The use of a VCSEL is advantageous compared to LED or EEL because of its stable and narrow spectral emission (allows strong filtering at the avalanche photodiode against environmental light) and because of the suitable emission pattern (rotationally symmetric with 20-30° FW1/e²). Additional optics can be used to tailor the emission cone further. Multiple channels i.e. arrays of several VCSELs and/or photodiodes especially in combination with optics enable a good angular coverage. Combined with algorithms linking signals from different channels a high angular resolution can be achieved with minimum effort and especially without any moving mechanical parts like scanners.

According to a further aspect a method of manufacturing a Vertical Cavity Surface Emitting Laser device is provided. The method comprises the steps of:
providing at least one first optical resonator on a semiconductor chip,
providing at least one electrically conducting layer for electrically pumping the at least one optical resonator,
structuring the electrically conducting layer such that the electrically conducting layer is arranged around an extended area comprising a first light emission area of the first optical resonator and at least one extension area such that the extended area is bigger than the first light emission area.

The method steps are not necessarily performed in the presented sequence.

According to a further aspect a metallization lift off mask for providing a lift off layer for removing parts of a conducting layer is provided. The metallization lift off mask comprises at least one structure for removing the conducting layer above a first light emission area of a Vertical Cavity Surface Emitting Laser device. The metallization lift off mask further comprises at least one extension structure for providing at least one extension area in the conducting layer. The at least one first light emission area and the at least one extension area define a connected extended area which is bigger than the first light emission area.

It shall be understood that the VCSEL device according to any embodiment described above and the method of manufacturing the VCSEL device have similar and/or identical embodiments, in particular, as defined in the dependent claims.

It shall be understood that a preferred embodiment of the invention can also be any combination of the dependent claims with the respective independent claim. Further advantageous embodiments are defined below.

### BRIEF DESCRIPTION OF THE DRAWINGS

These and other aspects of the invention will be apparent from and elucidated with reference to the embodiments described hereinafter.

The invention will now be described, by way of example, based on embodiments with reference to the accompanying drawings.

In the drawings:
Fig. 1 shows a principal sketch of a prior art metallization lift off mask
Fig. 2 shows a principal sketch of a first embodiment of a metallization lift off mask
Fig. 3 shows a cross-section of a first embodiment of a VCSEL device which is produced by means of the metallization lift off mask shown in Fig. 2 Fig. 4 shows a cross section of a second embodiment of a VCSEL device
Fig. 5 shows a cross-section of an optical sensor according to a first embodiment
Fig. 6 shows a principal sketch of a mobile device comprising an optical sensor
Fig. 7 shows a principal sketch of a method of manufacturing the laser device
In the Figures, like numbers refer to like objects throughout. Objects in the Figures are not necessarily drawn to scale.

### DETAILED DESCRIPTION OF EMBODIMENTS

Various embodiments of the invention will now be described by means of the Figures.

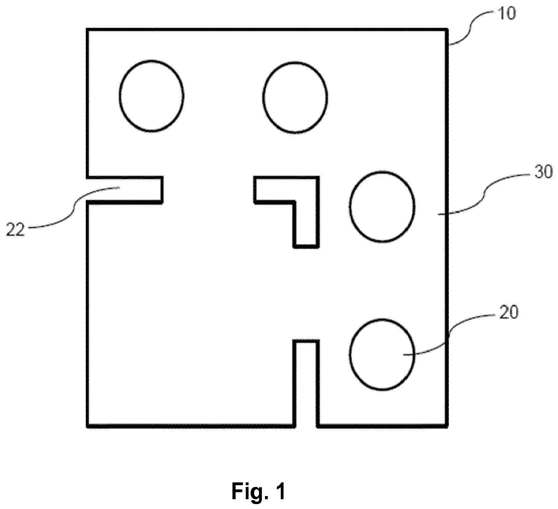

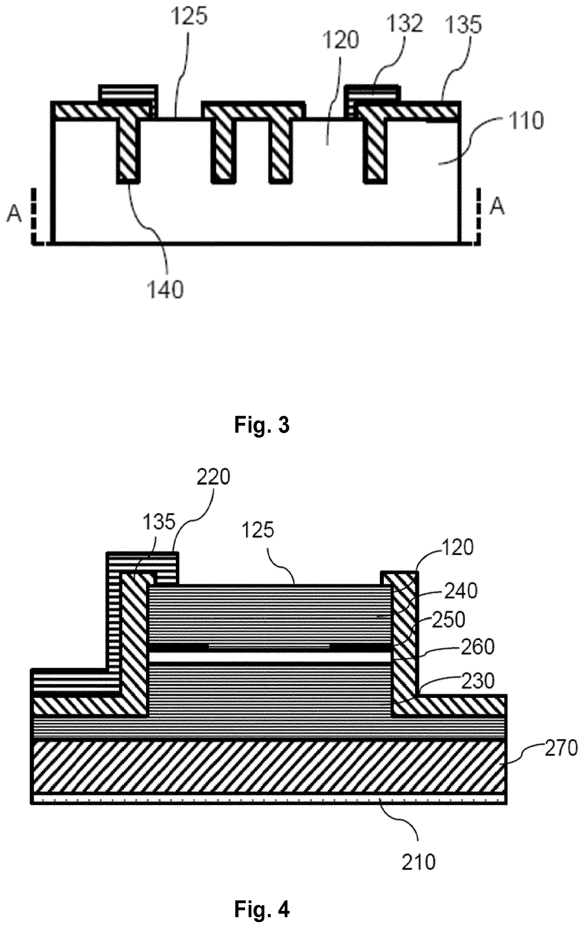

Fig. 1 shows a principal sketch of a prior art metallization lift off mask 10 for manufacturing a VCSEL device especially for providing a sacrificial layer for removing a conducting layer 132 (see Fig. 3) by means of a lift off process. The metallization lift off mask 10 comprises a metallization area 30, alignment marks 22 and four light emission areas 20. The metallization area 30 is used after depositing and structuring the conducting layer 132 to electrically contact the VCSEL device and to supply an electrical current to the four optical resonators such that laser light can be emitted through the light emission areas 20 during operation of the VCSEL device. The metallization area 30 surrounds the four light emission areas 20 and a part of the alignment mark 22. This results in small isolated "flakes" or particles of conducting material which are removed during lift off. The size of the area which is used to enable laser light emission via the light emission areas 20 is determined by the intended diameter of laser beam. The metallization area 30 therefore defines in the prior art approach together with a current confinement layer (e.g. oxide aperture) an aperture for emission of laser light. The size of the aperture depends on the intended application and may, for example, be characterized for optical sensors by a diameter between 2 and 15 µm. The metallization area 30 around the light emission areas 20 is usually arranged such that a symmetric current supply with respect to the center of the respective light emission area 20 is enabled. Experiments have shown that the small flakes of conducting material reduce the yield during production due to re-deposition and cause risks with respect to reliability because it is difficult to detect re-deposited flakes.

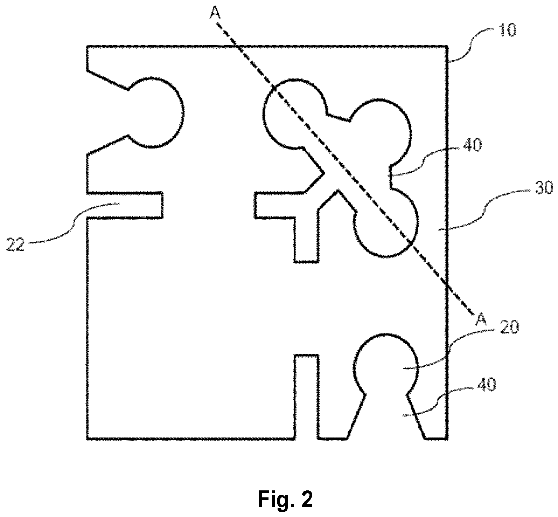

Fig. 2 shows a principal sketch of a first embodiment of a metallization lift off mask 10 according to the present invention. The general design is similar as discussed with respect to Fig. 1. The difference is that the areas of the parts of the conducting layer which have to be removed during lift off is increased by means of extension areas 40. The isolated small part of the alignment mark 22 shown in Fig. 1 is, for example, comprised by an extended area further comprising two light emission areas 20. The light emission areas 20 are extended by means of notches increasing the size of the respective light emission area 20 in a predefined direction with respect to the center of the respective light emission area 20. The conducting layer therefore builds a ring or (partly) surrounding electrode around the light emission area 20 which is interrupted by the notch. One, two or more notches or other extension areas 40 may be used in order to increase the size of the extended area by, for example, connecting functional areas (e.g. light emission areas 20, alignment marks 22 etc.) from which the conducting layer is removed during the lift off process.

Fig. 3 shows a cross-section of a first embodiment of a VCSEL device which is processed by means of the metallization lift off mask 10 shown in Fig. 2 along line A-A. The first VCSEL device comprises a semiconductor chip 110 comprising a multitude of semiconductor layers (not shown) and trenches 140 in the semiconductor chip 110 which are provided around mesas 120. Each mesa 120 comprises one optical resonator (see Fig. 4 with respect to details about the optical resonator). An isolation layer 135 is deposited and structured. The isolation layer 135 comprises openings at the position of the light emission areas (laser facet 125) and fills the trenches around the mesas. A conducting layer 132 is provided and structured by means of the metallization lift off mask 10 described in Fig. 2. The extended area comprises as indicated in Fig. 2 the two light emission areas 20 of the mesas 120 shown in the cross section in Fig. 3 and the area in between the two light emission areas 20. The conducting layer 132 provides an electrical contact to the semiconductor material of the mesas 120 in order to enable electrical pumping of the optical resonator in the respective mesas 120.

Fig. 4 shows a cross section of a second embodiment of a VCSEL device. The second VCSEL device comprises an optical resonator embedded in a mesa 120. The optical resonator comprises a first Dielectric Bragg Reflector (DBR) 230, a second DBR 240 and an active layer 260 sandwiched between the first DBR 230 and the second DBR 240. The first DBR 230 is highly reflective (>99%) and the second DBR 240 does have a somewhat smaller reflectivity (>95%) in order to enable laser emission via the second DBR 240. The VCSEL device is thus a so called top emitter. The active layer 260 comprises a number of layers building a Quantum Well structure. The first DBR 230 is arranged on a substrate 270 like a GaAs-Substrate. The VCSEL device is contacted by means of a first electrode 210 and a second electrode 220. The first electrode 210 is provided on the side of the substrate 270 opposite to the first DBR 230. The second electrode 220 is provided on top of the second DBR 240 and on top of a structured isolation layer 135. The second electrode 220 may comprise a conducting layer 132 similar as discussed with respect to Fig. 3. A confinement layer 250 restricts the current flow through the active layer 260 to a defined in this case circular area of the active layer 260. The confinement layer 250 comprises an electrically essentially nonconductive oxide area with a circular hole processed by lateral oxidization of the confinement layer 250 after etching the mesa. The confinement layer 250 is in this case arranged on top of the active layer 260. The confinement layer may also be positioned within the first DBR 230 or the top second DBR 240. Variations of the arrangement of the layers without affecting the functionality of the layers are well known to those skilled in the art. The second electrode 220 borders or surrounds the laser facet 125 (light emission area) 320° around a center axis of the optical resonator as shown on the left side in order to electrically pump the active layer 260 within the optical resonator. The conducting layer 132 is removed on the right side in order to provide an extended area in the 40° sector around the center axis not covered by the conducting layer.

Another conducting layer which may be comprised by the first electrode 210 may be structured in the same way in case of a, for example, bottom emitter emitting laser light through the substrate 270.

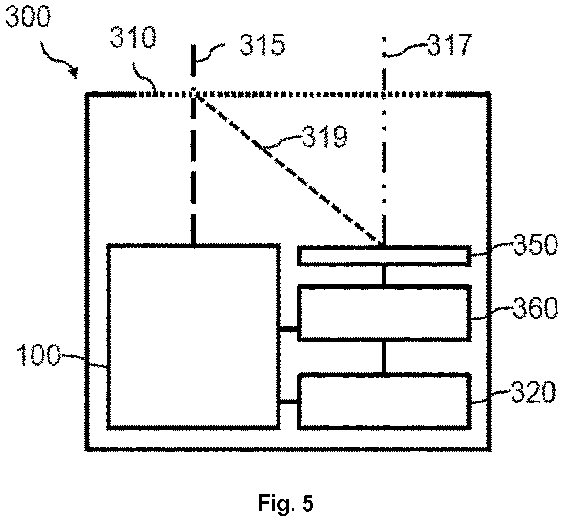

Fig. 5 shows a cross-section of an optical sensor 300 according to a first embodiment. The optical sensor 300 comprises a VCSEL device 100, a transmission window 310 and a driving circuit 320 for electrically driving the VCSEL device 100. The driving circuit 320 is electrically connected to the VCSEL device 100 to supply electrical power to the VCSEL device 100 in a defined way. The driving circuit 320 comprises a memory device for storing data and instructions to operate the driving circuit 320 and a processing unit for executing data and instructions to operate the driving circuit 320. The optical sensor 300 further comprises a photo detector 350 and an evaluator 360. The photo detector 350 is in this case a photo diode but may be any preferably semiconductor device which can be used to detect laser light emitted by the laser device. The photo detector 350 should be as sensitive as possible for the photons emitted by the laser and should have a fast measurement time. A preferred technology are e.g. avalanche photodiodes or even more so called SPADs (single photon avalanche diodes) as well as arrays of the same. The evaluator 360 comprises at least one memory device like a memory chip and at least one processing device like a microprocessor. The evaluator 360 is adapted to receive data from the driving circuit 320 and optionally from the VCSEL device 100 in order to determine a time t₁ at which emitted laser light 315 leaves the extended cavity in the form of a laser pulse. The evaluator 360 further determines based on this time t₁ and the repetition rate provided by means of the driving circuit 320 whether reflected laser light 317 detected by the photo diode originates from the laser pulse emitted at time t₁. A time t₂ is recorded if the reflected laser light 317 originates from the laser pulse and the distance to the object which reflected the laser pulse is calculated by means of the time of flight Δt=t₂-t₁ and the velocity of the laser pulse c. A small part of the emitted laser light 315 is reflected at the transmission window 310 and used as control signal 319. The control signal 319 is received by means of the photo detector 350 much earlier than the reflected laser light 317. The evaluator 360 is therefore able to differentiate between reception of control signal 319 and reflected laser light 317. The signal strength of the received control signal 319 is compared by means of the evaluator 360 with a reference signal strength stored in the memory device of the evaluator 360. The evaluator 360 sends a power reduction signal to the driving circuit 320 as soon as the signal strength of the received control signal 319 exceeds a threshold value which is based on the reference signal strength in order to guarantee eye safety of the optical sensor 300.

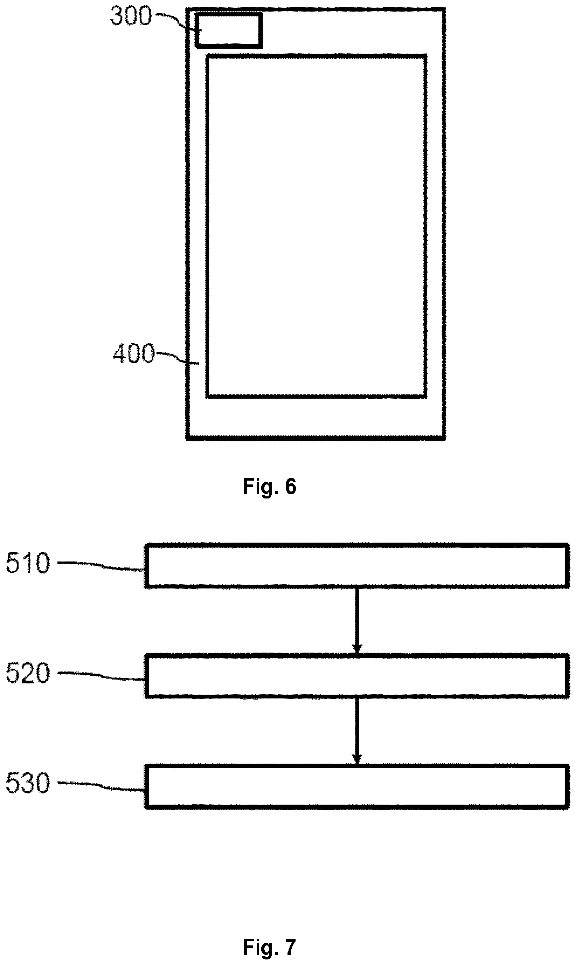

Fig. 6 shows a principal sketch of a mobile communication device 400 comprising an optical sensor 300. The optical sensor 300 can, for example, be used in combination with a software application running on the mobile communication device 400. The software application may use the optical sensor 300 for sensing applications. Such sensing applications may be time of flight measurements for distance detection, camera autofocus, 3-D imaging of a scene or a gesture based user interface.

Fig. 7 shows a principal sketch of a method of manufacturing the laser device 100. In step 510 one, two three or more optical resonators are provided on a semiconductor chip 110. An electrically conducting layer 132 for electrically pumping the at least one optical resonator is provided step 520. The electrically conducting layer 132 is structured in step 530 such that the electrically conducting layer 132 is arranged around an extended area comprising a first light emission area 20 of a first optical resonator and at least one extension area such that the extended area is bigger than the first light emission area.

It is a basic idea of the present invention to provide a VCSEL device 100 comprising at least one structured electrically conducting layer 132 for electrically pumping the VCSEL device 100, wherein the at least one structured conducting layer 132 is structured such that areas from which the conducting layer 132 is removed are characterized by a minimum size of 30 µm², preferably of 40 µm² and most preferably of 50 µm².

While the invention has been illustrated and described in detail in the drawings and the foregoing description, such illustration and description are to be considered illustrative or exemplary and not restrictive.

From reading the present disclosure, other modifications will be apparent to persons skilled in the art. Such modifications may involve other features which are already known in the art and which may be used instead of or in addition to features already described herein.

Variations to the disclosed embodiments can be understood and effected by those skilled in the art, from a study of the drawings, the disclosure and the appended claims. In the claims, the word "comprising" does not exclude other elements or steps, and the indefinite article "a" or "an" does not exclude a plurality of elements or steps. The mere fact that certain measures are recited in mutually different dependent claims does not indicate that a combination of these measures cannot be used to advantage.

Any reference signs in the claims should not be construed as limiting the scope thereof.

### LIST OF REFERENCE NUMERALS:

- 10: metallization lift off mask
- 20: light emission area
- 22: alignment mark
- 30: metallization area
- 40: extension area
- 100: VCSEL device
- 110: semiconductor chip
- 120: mesa
- 125: laser facet
- 132: conducting layer
- 135: isolation layer
- 140: trench
- 160: bonding area
- 210: first electrode
- 220: second electrode
- 230: first DBR
- 240: second DBR
- 250: confinement layer
- 260: active layer
- 270: substrate
- 280: protective coating
- 300: optical sensor
- 310: transmission window
- 315: emitted laser light
- 317: reflected laser light
- 319: control signal
- 320: driving circuit
- 350: photo-detector
- 360: evaluator
- 400: mobile communication device
- 510: step of providing at least one first optical resonator
- 520: step of providing at least one electrically conducting layer
- 530: step of structuring the electrically conducting layer

## Claims

1. A Vertical Cavity Surface Emitting Laser device (100) comprising at least one first optical resonator, a first electrode (210) and a second electrode (220), wherein the first electrode (210) and the second electrode (220) are arranged to electrically pump the first optical resonator during operation of the Vertical Cavity Surface Emitting Laser device (100), wherein the first electrode (210) or the second electrode (220) comprises at least one electrically conducting layer (132), wherein the electrically conducting layer (132) is arranged around an extended area comprising a first light emission area (20) of the first optical resonator and at least one extension area (40) such that the extended area is bigger than the first light emission area (20).

2. The Vertical Cavity Surface Emitting Laser device (100) according to claim 1, wherein the extension area (40) comprises at least one notch extending the extended area beyond the size of the first light emission area (20).

3. The Vertical Cavity Surface Emitting Laser device (100) according to anyone of the preceding claims, wherein the extension area (40) breaks asymmetry of the first light emission area.

4. The Vertical Cavity Surface Emitting Laser device (100) according to anyone of the preceding claims, wherein the extended area is at least 1.5 times bigger than the first light emission area (20).

5. The Vertical Cavity Surface Emitting Laser device (100) according to anyone of the preceding claims, wherein the extended area is **characterized by** a size of at least 30 µm².

6. The Vertical Cavity Surface Emitting Laser device (100) according to anyone of claims 2-5, wherein the at least one notch disturbs symmetry of current injection around the light emission area (20) during operation of the Vertical Cavity Surface Emitting Laser device (100).

7. The Vertical Cavity Surface Emitting Laser device (100) according to anyone of the preceding claims, wherein the Vertical Cavity Surface Emitting Laser module comprises at least a second optical resonator with a second light emission area (20), wherein the extended area comprises the first light emission area (20) and the second light emission area (20).

8. The Vertical Cavity Surface Emitting Laser device (100) according to claim 7, wherein the electrically conducting layer (132) is arranged to electrically pump the first optical resonator and the second optical resonator in parallel.

9. A Vertical Cavity Surface Emitting Laser module comprising the Vertical Cavity Surface Emitting Laser device (100) according to any one of the claims 1-8, the Vertical Cavity Surface Emitting Laser module further comprises a driving circuit (320) for electrically pumping the optical resonator.

10. An optical sensor (300) comprising the Vertical Cavity Surface Emitting Laser module according to claim 9.

11. The optical sensor (300) according to claim 10 comprising at least one photo-detector (350) being adapted to receive reflected laser light of a corresponding laser pulse emitted by the Vertical Cavity Surface Emitting Laser device (100), wherein the optical sensor further comprises an evaluator (360), wherein the evaluator (360) is adapted to identify the reflected laser light of the corresponding laser pulse, and wherein the evaluator (360) is further adapted to determine a time of flight between a time of reception of the reflected laser light and a time of emission of the corresponding laser pulse.

12. A mobile communication device (400), the mobile communication device (400) comprising at least one optical sensor (300) according to claims 10 or 11.

13. A method of manufacturing a Vertical Cavity Surface Emitting Laser device (100) (100), the method comprising the steps of:
providing at least one first optical resonator on a semiconductor chip (110),
providing at least one electrically conducting layer (132) for electrically pumping the at least one optical resonator,
structuring the electrically conducting layer (132) such that the electrically conducting layer (132) is arranged around an extended area comprising a first light emission area (20) of the first optical resonator and at least one extension area such that the extended area is bigger than the first light emission area (20).

14. A metallization lift off mask (10) for providing a lift off layer for removing parts of a conducting layer (132), wherein the metallization lift off mask (10) comprises at least one structure for removing the conducting layer (132) above a first light emission area (20) of a Vertical Cavity Surface Emitting Laser device (100), wherein the metallization lift off mask (10) further comprises at least one extension structure (40) for providing at least one extension area in the conducting layer (132), wherein the at least one first light emission area (20) and the at least one extension area define a connected extended area which is bigger than the first light emission area (20).
